# EUROPEAN PATENT SPECIFICATION

(11) **EP 2 555 347 B1**
(45) Date of publication and mention of the grant of the patent: **31.12.2014**
(21) Application number: 12178887.1
(22) Date of filing: 01.08.2012
(51) Int. Cl.: H01R 43/20, H05K 13/06

(54) **Connector supporting shuttle for automatic maschines for providing electrical wiring**
Steckverbinderzuführungsträger für automatische Verdrahtungsgeräte
Chariot porte connecteurs pour machines automatiques de câblage électrique

(30) Priority: 02.08.2011 IT PD20110256
(43) Date of publication of application: 06.02.2013
(73) Proprietor: KM Corporate S.r.l., 35010 Vigodarzere, Frazione Tavo (PD) (IT)
(72) Inventor: Carlotto, Vladimiro, 00039 Zagarolo RM (IT)

(56) References cited:
- DE-A1- 4 002 193
- US-A1- 2002 174 537
- US-A1- 2004 143 966
- US-A1- 2006 064 870
- US-B1- 6 381 831

## Description

The present invention relates to a connector supporting shuttle for automatic machines for providing electrical wiring.

Currently known apparatuses for providing electrical wiring perform automatically the insertion of electrical wires in corresponding receptacles of connectors that support electrical terminals to which the wires are connected.

These apparatuses also provide for the possibility of complete wirings constituted by pairs of connectors interconnected by a plurality of wires.

Currently there are different apparatuses adapted to provide electrical wirings between electrical wires and terminals provided in connectors made of plastic material. An example of said apparatuses, according to the preamble of claim 1, is disclosed in US 2002/174537 A1.

Among the various automation systems that exist, mention must be made of the automatic placement in the connection region of the connector being processed, which is separated from a reel of mutually series-connected connectors, and the positioning of individual wires in the connection region.

Wiring machines are generally each designed specifically for particular applications dedicated to specific connectors having predefined dimensions and therefore have a low flexibility in adapting to different connectors.

In particular, in many known automatic wiring machines the connectors are induced to slide in translation tracks which are contoured specifically for such connectors.

The use of the same automatic machine to wire different connectors requires demanding operations for modifying the movement systems of the connectors and of such translation tracks, which are arranged at the actual wiring means.

The aim of the present invention is to provide a connector supporting shuttle for automatic machines for providing electrical wiring that is capable of obviating the cited drawbacks of known machines.

Within this aim, an object of the invention is to provide a connector supporting shuttle that allows the provision of automatic connector wiring machines that are highly flexible, i.e., can be configured conveniently to be able to work with connectors having different dimensions.

Another object of the invention is to provide a connector supporting shuttle for automatic machines for providing electrical wiring that is intuitive to use or easy to handle.

Another object of the invention is to propose a connector supporting shuttle for automatic machines for providing electrical wiring that can be manufactured with known equipment and technologies.

This aim and these and other objects that will become better apparent hereinafter are achieved by a connector supporting shuttle for automatic machines for providing electrical wiring, the connector supporting shuttle comprising a platelike body which supports at least one first connector supporting plate, for a first type of connector, coupled to said platelike body by reversible fixing means for the optional removal and replacement of said first connector supporting plate with an additional second connector supporting plate contoured so as to support a second type of connector, said platelike body also comprising locking means for locking the connectors on said at least one connector supporting plate, said locking means being adaptable to the size of the connectors supported by the connector supporting plate in use, said platelike body having at least one part which is preset for fixing to movement means for said platelike body.

Further characteristics and advantages of the invention will become better apparent from the description of a preferred but not exclusive embodiment of the connector supporting shuttle according to the invention, illustrated by way of non-limiting example in the accompanying drawings, wherein:

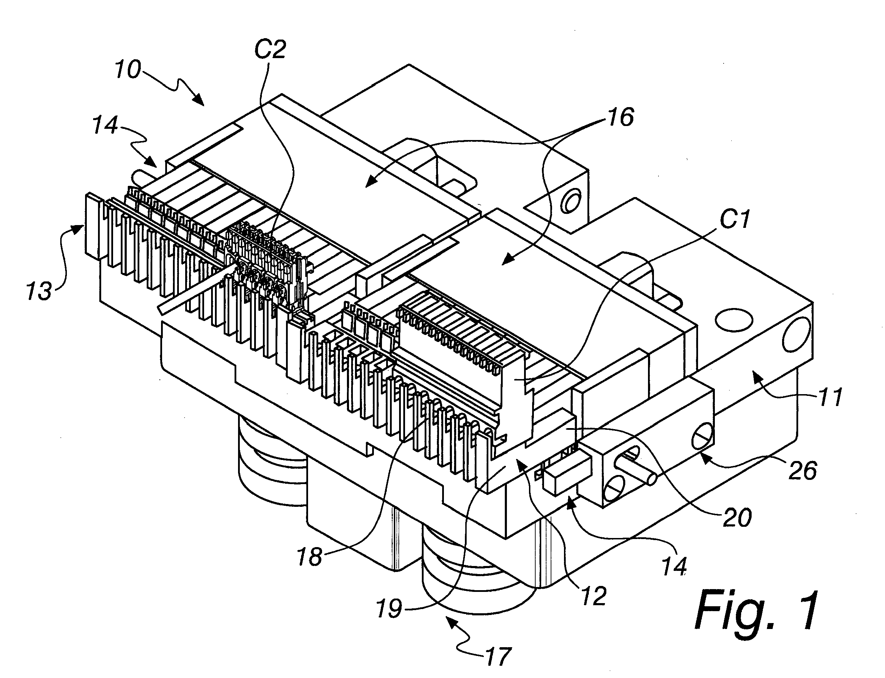

Figure 1 is a perspective view of a connector supporting shuttle according to the invention;
Figure 2 is an exploded perspective view of the shuttle of Figure 1;
Figure 2a is a view of a detail of Figure 2;
Figure 3 is a sectional side view of the shuttle according to the invention in an inactive configuration;
Figure 4 is the same sectional side view as in Figure 3, with the shuttle according to the invention in an active configuration;
Figure 5 is the same sectional side view as in Figures 3 and 4, with the shuttle according to the invention in a subsequent operating configuration;
Figures 6 and 7 are each a sectional side view of a shuttle according to the invention in a variation of use;
Figure 8 is a schematic top view of the platelike body, with the connector supporting plates, of the shuttle according to the invention;
Figures 9 and 10 are each a side view, in two different configurations of use, of a detail of the connector supporting shuttle according to the invention;
Figure 11 is a sectional side view of said movement means.

With reference to the figures, a connector supporting shuttle for automatic machines for providing electrical wiring is generally designated by the reference numeral 10.

In the embodiment described here, which is to be understood as a non-limiting example of the invention, the shuttle 10 comprises a platelike body 11 which supports two connector supporting plates, 12 and 13 respectively, which are each shaped for a corresponding type of connector, designated by C1 and C2 in the figures.

Each one of the connector supporting plates 12 and 13 is coupled to the platelike body 11 by fixing means 14, better described hereinafter, which are reversible for the optional removal and replacement of the first connector supporting plates 12 and 13 with additional different second connector supporting plates 15 shaped to support a different type of connector C3.

The platelike body 11 also supports means 16 for locking the connectors on the connector supporting plates 12, 13 and 15.

The locking means 16, also described in more detail hereinafter, can be adapted to the size of the connectors supported by the connector supporting plate being used.

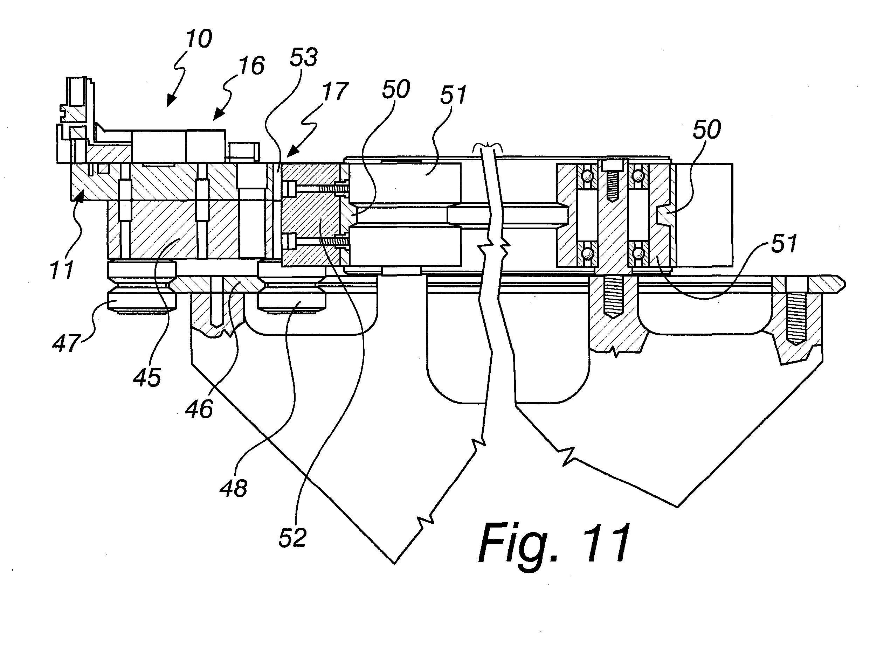

The platelike body 11 has a lower rear part 17 that is preset for being fixed to movement means, exemplified in Figure 11 and to be understood as being of a known type, for the platelike body 11.

A connector supporting plate 12 is described, where it is understood that the other cited connector supporting plates 13 and 15 are substantially equivalent.

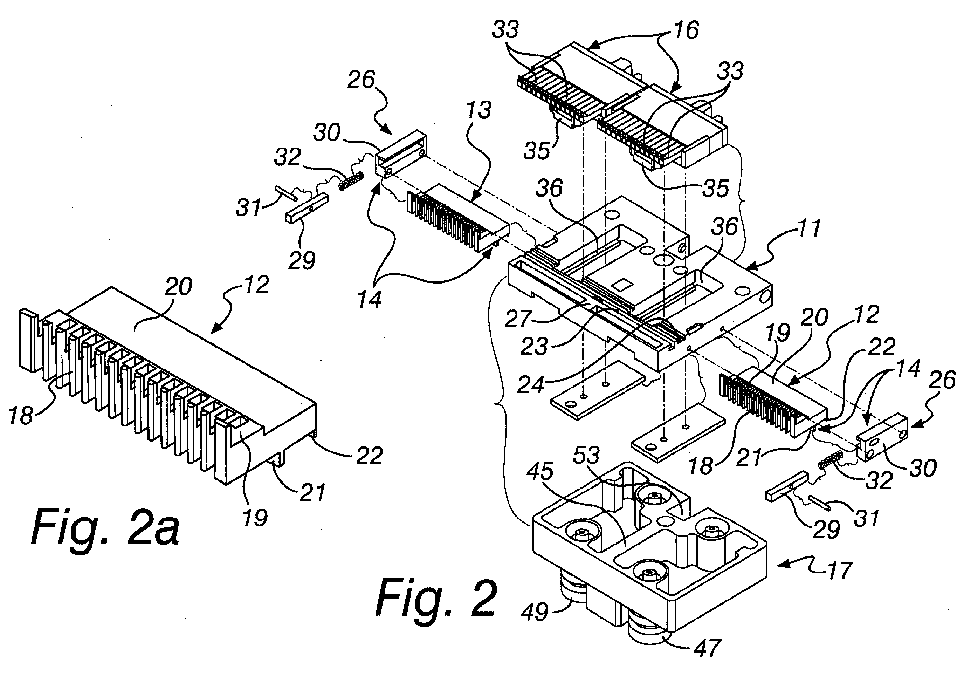

The connector supporting plate 12, clearly visible in Figure 2a, has:
- a comb-like front edge 18, i.e., at the side for the passage of the wiring cables,
- a central part 19 for supporting the connectors, and an open rear part 20 for the passage of the locking means 16.

Two ridges, respectively 21 and 22, extend from the lower surface of the plate and are adapted to be inserted each in a corresponding complementarily shaped guide 23 and 24, defined on the platelike body 11, which can be accessed from one side of such platelike body.

The reversible fixing means 14 for the optional removal and replacement of the first connector supporting plate 12 or 13 with an additional second connector supporting plate 15 comprise the two ridges 21 and 22, the first front ridge 21 having a front tooth 25 for preventing lifting.

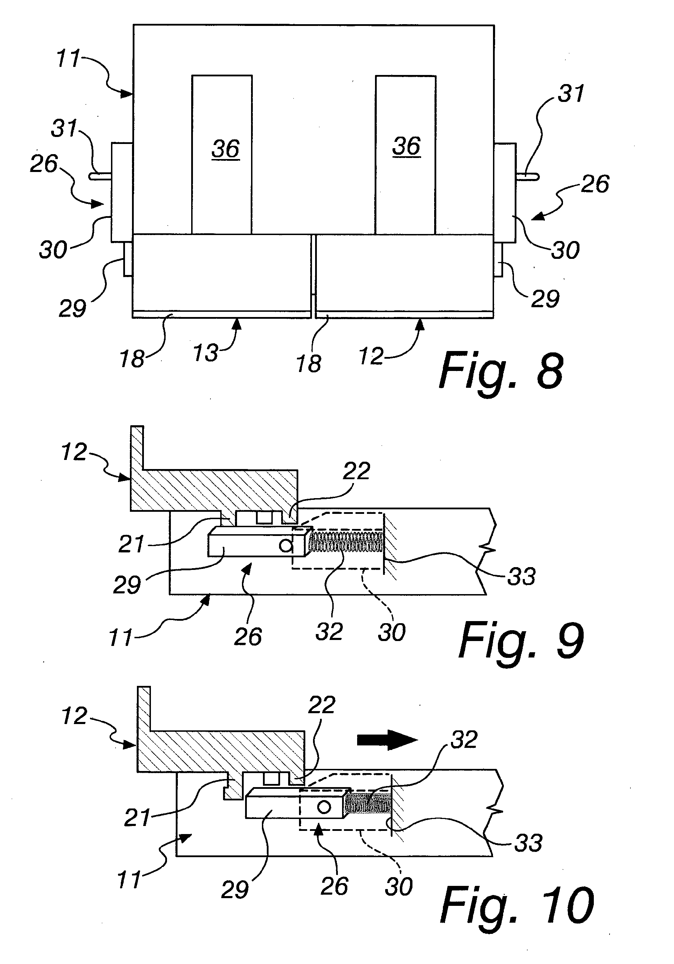

The fixing means 14 also comprise, on the sides of the platelike body 11, extraction preventing means 26, shown in Figures 8 to 10, which are adapted to prevent the movement of the first ridge 21 once it has been inserted in the corresponding guide 23.

The connector supporting plate 12 and 13 is thus locked between the extraction preventing means 26, and, on the opposite side, a stroke limiting abutment 27 defined on the platelike body 11 and particularly within a first guide 23 for the first ridge 21.

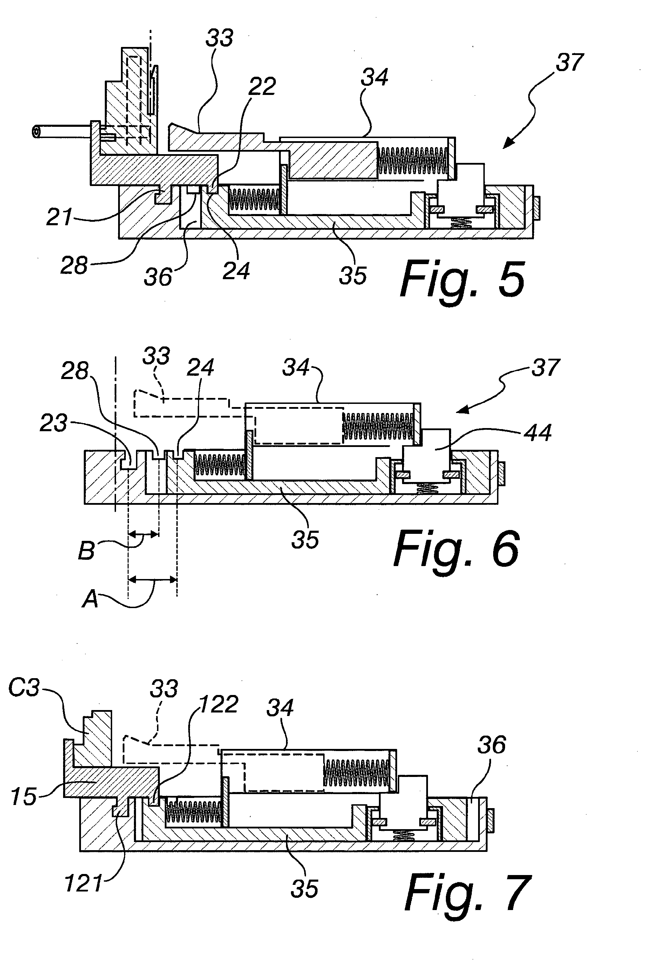

On the platelike body 11 there is a first guide 23 for the first ridge 21, with a front tooth for preventing lifting, and there is a plurality of laterally adjacent and parallel second guides, for example two second guides 24 and 28, as in the sectional view of Figure 6, to be occupied selectively with the second ridge 22 of the connector supporting plate 12, 13 or 15.

In the embodiment described here of the shuttle 10 according to the invention, which is to be understood as a non-limiting example of the invention, a first connector supporting plate 12, like 13, has two ridges 21 and 22, the first ridge 21 being intended for the corresponding first guide 23, the second ridge 22 being intended for the second guide 24, with the second ridge and the second guide formed at a first center distance A from the respective first ridge and first guide, again as shown in Figure 6.

The second connector supporting plate 15 instead has two ridges 121 and 122, the first ridge 121 being intended for the corresponding first guide 23, the second ridge 122 being intended for a different second guide 28, with the second ridge and the second guide formed at a second center distance B from the respective first ridge and first guide, in the example described here A being greater than B.

The second plate 15 is sized, as mentioned above, differently so as to support connectors C3 of different types which therefore have different base dimensions.

The extraction preventing means 26 are constituted by a retractable block 29, which in the active position is arranged so as to affect the extraction opening of the first ridge 21 or 121, as in Figures 9 and 10.

The block 29 is designed to be subjected to a translational motion toward the inside of a housing 30, which is fixed to the corresponding side of the pl atelike body 11, so as to clear the extraction opening, by means of a grip protrusion 31 that is jointly connected thereto.

Elastic contrasting thrust means, for example a helical compression spring 32, are provided within the housing 30 and are interposed between the internal end of the block 29 and the bottom wall 33 of the seat of the block 29 inside the housing 30.

Thus, by pulling back manually the protrusion 31 a translation of the block 29 is achieved which releases the extraction of the first ridge 21 or 121, allowing in practice the removal and therefore the replacement of the connector supporting plate in use.

The means 16 for locking the connectors on a connector supporting plate 12, 13 or 15 are constituted, for each connector supporting plate, by a series of laterally adjacent pushers 33 supported by a pusher block 34, which in turn is fixed to the platelike body 11.

The pusher block 34 is supported by a base 35 that can be inserted for fixing in a corresponding seat 36 defined on the platelike body 11.

The length of the seat 36 is greater than the length of the base 35, so that the base 35 can be fixed in the seat 36 in a plurality of positions selectively, depending on the dimensions of the connectors to be retained on the connector supporting plate.

In Figure 6, for example, the base 35 is arranged completely retracted in the seat 36, so that the pushers are in the best position for blocking connectors of a relatively large size; in Figure 7, instead, the base 35 is arranged in a completely advanced position so as to lock relatively small connectors.

Between the base 35 and the corresponding pusher block 34 reversible means 37 are interposed for retaining the pusher block 34 in a first active configuration for locking the connectors.

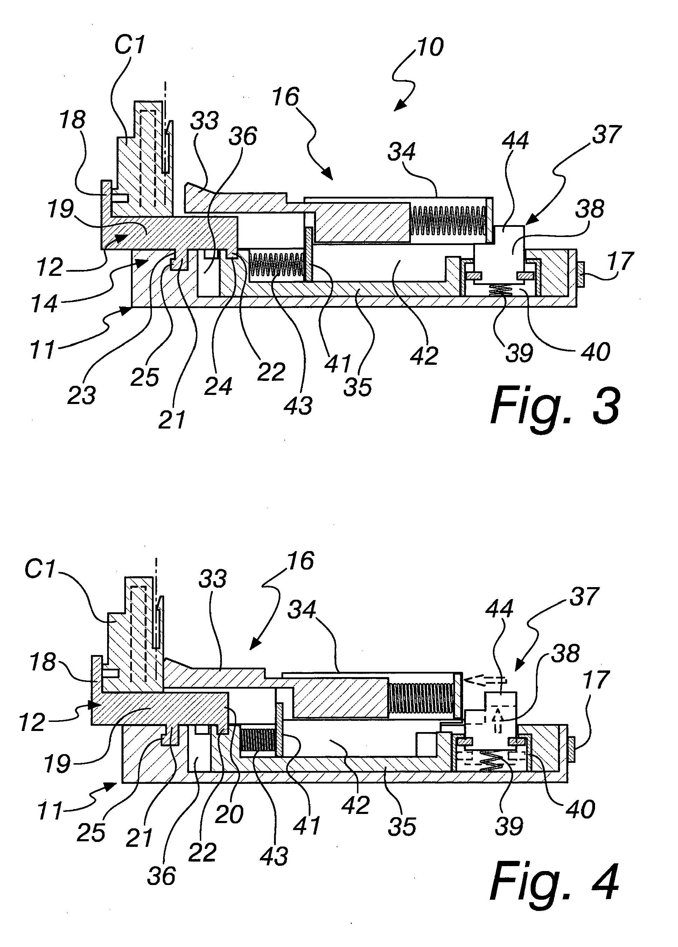

The disengagement of the retention means 37 defines the retraction of the pusher block 34 into a second inactive configuration for connector unloading, as shown in Figures 3,5,6 and 7.

In the example of the invention described here, the pusher block retention means 37 are constituted by a snap-acting device, which comprises a rear locking element 38, which is pushed upward in the locking configuration by underlying elastic means, for example a spring 39, which are arranged so as to operate in a corresponding seat 40 defined in the base 35 that supports the pusher block 34.

The pusher block 34 has a lower part 41 that is inserted so as to perform a translational motion in a corresponding guide 42 also defined on the base 35.

Additional elastic means, i.e., another spring 43, are arranged so as to operate in the guide 42 and are adapted to push the pusher block 34 so as to retract with respect to the connector supporting plate 12, 13 or 15, from the active configuration of Figure 4 to the inactive configuration of Figure 5, once the locking element 38 has been lowered, so as to retract into its corresponding seat 40 with compression of the underlying elastic means, until a portion of retracting stroke for said pusher supporting block is released.

The locking element 38 has an upper part 44 that protrudes from the base 35 in the lowered configuration and is adapted to act as a stroke limiter for the retraction of the pusher block.

The rear and lower part 17 preset for the fixing of the platelike body 11 to movement means for said platelike body is constituted by a carriage 45, clearly visible in Figures 2 and 11, on which the platelike body 11 is fixed, provided with four free pulleys 47 etcetera, having a vertical axis, which are mutually opposite in pairs and are adapted to define the sliding engagement with a guiding bar 46 that extends so as to define the entire path for the shuttle 10.

The shuttle 10 is moved along said path by a belt 50, which is arranged so as to move between a plurality of rollers 51 having a vertical axis, which are fixed to the frame of the automatic wiring machine.

An insert 52 is in fact screwed to the belt 50 and is adapted to be locked within a corresponding seat 53 formed at the rear of the shuttle 10.

In practice it has been found that the invention achieves the intended aim and objects.

In particular, the invention has provided a connector supporting shuttle for automatic machines for providing electrical wiring that allows the provision of automatic connector wiring machines that are highly flexible, i.e., can be set up conveniently so as to be able to operate with connectors having different dimensions.

This is in fact a shuttle with connector locking systems that adapt to the dimensions of said connector and at the same time center it with respect to a preset and fixed position of the equipment preset to work on the connectors.

Last but not least, the invention provides a connector supporting shuttle for automatic machines for providing electrical wiring that can be manufactured with known systems and technologies.

The invention thus conceived is susceptible of numerous modifications and variations, all of which are within the scope of the appended claims; all the details may further be replaced with other technically equivalent elements.

In practice, the materials used, as well as the contingent shapes and dimensions, may be any according to requirements and to the state of the art.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A connector supporting shuttle (10) for automatic machines for providing electrical wiring, the connector supporting shuttle comprising a platelike body (11) which supports at least one first connector supporting plate (12), for a first type of connector (C1), coupled to said platelike body (11) by reversible fixing means (14) for the optional removal and replacement of said first connector supporting plate (12) with an additional second connector supporting plate (15) contoured so as to support an additional type of connector (C3), the connector supporting shuttle being **characterized in that** said platelike body (11) also comprises locking means (16) for locking the connectors on said at least one connector supporting plate (12, 15), said locking means (16) being adaptable to the size of the connectors supported by the connector supporting plate in use, said platelike body (11) having at least one part (17) which is preset for fixing to movement means for said platelike body.

2. The connector supporting shuttle according to claim 1, **characterized in that** said connector supporting plate (12) has a comb-like front edge (18), i.e., at the side for the passage of the wiring cables, a central part (19) for supporting the connectors, and an open rear part (20) for the passage of the locking means (16), at least one ridge (21) extending from the lower surface of said plate and being adapted to be inserted in a corresponding complementarily shaped guide (23), defined on said platelike body (11), which can be accessed from one side of said platelike body (11).

3. The connector supporting shuttle according to one or more of the preceding claims, **characterized in that** said reversible fixing means (14) for the optional removal and replacement of said first connector supporting plate (12) with an additional second connector supporting plate (15) are constituted by two ridges (21, 22) of said at least one ridge, at least one (21) of which has a front tooth (25) for preventing lifting, each ridge (21, 22) being intended for a corresponding guide (23, 24) on the platelike body (11), on the sides of said platelike body there being extraction preventing means (26) adapted to prevent the movement of at least one ridge once it has been inserted in the corresponding guide, said connector supporting plate (12) being locked between said extraction preventing means (26), and, on the opposite side, a stroke limiting abutment (27) defined on said platelike body.

4. 3 The connector supporting shuttle according to claim 3, **characterized in that** on said plate-like body (11) there is a first guide (23) for said first ridge (21) with a front tooth for preventing lifting and there is a plurality of laterally adjacent and parallel second guides (24, 28) to be occupied selectively with a second ridge (22) of the connector supporting plate.

5. The connector supporting shuttle according to claim 3 in claim 4, **characterized in that** said extraction preventing means (26) are constituted by a retractable block (29), which in the active position is arranged so as to affect the extraction opening of the first ridge (21), said block (29) being designed to be subjected to a translational motion toward the inside of a housing (30) which is fixed to the corresponding side of the platelike body (11), so as to clear said extraction opening, by means of a grip protrusion (31) that is jointly connected thereto, elastic contrasting thrust means being provided within said housing (30) and being interposed between the internal end of the block (29) and the bottom wall (33) of the seat of the block inside the housing (30).

6. The connector supporting shuttle according to one or more of the preceding claims, **characterized in that** said means (16) for locking the connectors on said at least one connector supporting plate (12, 15) are constituted, for each connector supporting plate, by a series of laterally adjacent pushers (33) which are supported by a pusher block (34), which in turn is fixed to the platelike body (11).

7. The connector supporting shuttle according to claim 6, **characterized in that** said pusher block (34) is supported by a base (35) that can be inserted for fixing in a corresponding seat (36) defined in said platelike body (11), the length of said seat being greater than the length of said base.

8. The connector supporting shuttle according to claim 7, **characterized in that** between said base (35) and the corresponding pusher block (34) reversible means (37) are interposed for retaining the pusher block (34) in a first active configuration for locking the connectors, the disengagement of said retention means defining the retraction of said pusher block (34) into a second inactive configuration for connector unloading.

9. The connector supporting shuttle according to claim 8, **characterized in that** said reversible means (37) for retaining the pusher block are constituted by a snap-acting device, which comprises a rear locking element (38), which is pushed upward in the locking configuration by underlying elastic means arranged so as to operate in a corresponding seat (40) defined in said base (35) that supports the pusher block (34), said pusher block having a lower part (41) which is inserted so as to perform a translational motion in a corresponding guide (42) also defined on said base (35), where in said guide (42) additional elastic means are arranged so as to operate which are adapted to push said pusher block (34) so as to retract with respect to the connector supporting plate (12, 13, 15), from said active configuration to said inactive configuration, once said locking element (38) has been lowered, so as to retract into its corresponding seat (40) with compression of the underlying elastic means, until a portion of retracting stroke for said pusher supporting block is released, said locking element (38) having an upper part (44) that protrudes from said base (35) in the lowered configuration and is adapted to act as a stroke limiter for the retraction of the pusher block.

## Patentansprüche

1. Ein Konnektor unterstütztes Shuttle (10) für Automatik Maschinen zur Bereitstellung von elektrischen Leitungen, das Konnektor unterstützte Shuttle bestehend aus einer Platten förmigen Einrichtung (11), die mindestens eine erste Konnektor unterstützte Platte unterstützt (12), für eine erste Art von Konnektor (C1), gekoppelt mit genanntem Platten formigen Körper (11) durch umkehrbare Befestigungsmittel (14) für die optionale Entfernung und Ersatz der genannten ersten Konnektor unterstützten Platte (12) mit einer zusätzlichen zweiten Konvektor unterstützen Platte (15) konturiert um einen weiteren Konnektor Typ zu fordern (C3), das Konnektor unterstützte Shuttle gekennzeichnet in dem genannten Platten förmige Körper (11) umfasst auch Spermittel (16) zum sperren der Konnektoren auf mindestens einer besagten Unterstützungsplatte. (12, 15) Sperren bedeutet (16), anpassbar an die Größe der Konnektoren unterstützt von der Konnektoren unterstützenden Platte im Einsatz zu sein, besagter Platten förmige Körper (11), mit mindestens einem Teil (17) dass zur Fixierung der Bewegung des genannten Platten förmigen Körpers voreingestellt ist.

2. Das vom Konnektor unterstützte Shuttle nach Anspruch 1, gekennzeichnet in der genannten Konnektor Unterstützungsplatte (12) hat eine Kamm-artige Vorderkante (18), d.h., an der Seite für den Durchgang der Leitungskabel, eine zentrale Stelle (19) zur Unterstützung der Konnektoren und eine offenes Hinter teil (20) für den Durchgang der Sperren (16), mindestens eine Furche (21) weiterführend von der unteren Oberfläche der besagten Platte angepasst zur Einführung in eine entsprechende komplementäre Führungsschiene (23), definiert auf besagtem Platten förmigen Körper (11), auf welche von einer Seite des Platten förmigen Körpers zugegriffen werden kann (11)

3. Das Konnektor unterstützte Shuttle nach mindestens einer der vorangegangenen Ansprüche, charakterisiert in den genannten Umkenrungs Fixierungs-Mittel (14) für die optionale Entfernung und Ersatz der ersten genannten Konnektor Unterstützungsplatte (12) mit einer zusätzlichen zweiten Konnektor Unterstützungsplatte (15) werden durch zwei Gräte gebildet (21, 22) von mindestens einem genannten Grat, mindestens eine (21) die einen vorderen Zahn (25) zur Vermeidung einer Hebung besitzt, jeder Grat (21, 22) ist als korrespondierende Lenkung (23, 24) auf dem Platten ähnlichem Körper vorgesehen (11), auf den Seiten des besagten Platten förmigen Körpers sind Extraktion vorbeugende Maßnahmen (26) angepasst, um zu verhindern, dass die Bewegung von mindestens eines Grates stattfindet, sobald es in der korrespondierenden Furche eingefügt wurde, benannte Konnektor Verbindungsplatte (12) gesperrt zwischen genannter Extraktion Vorbeugungsmaßnahmen (26), und auf der gegenüberliegenden Seite, befindet sich eine Hubbegrenzung(27) definiert auf besagtem Platten ähnlichem Körper.

4. Das Konnektor unterstützte Shuttle nach Anspruch 3, charakterisiert in dem genannten Platten-ähnlichem Körper (11) das es einen ersten Lenker (23) für diese erste Furche gibt (21), mit einem vorderen Zahn zur Vermeidung von Hebung und es gibt eine Vielzahl von seitlich angrenzenden und parallelen zweiten Lenkern (24, 28) die selektiv mit einer zweiten Furche (22)auf der Konnektor unterstützten Platte betätigt werden.

5. Das Konnektor unterstützte Shuttle nach Anspruch 3 oder Anspruch 4, gekennzeichnet in den genannten Extraktion verhindernden Mitteln (26 sagte) gebildet von einen einziehbaren Block (29), der in der aktiven Position so angeordnet dass die Extraktions-Öffhung der ersten Furche beeinflusst wird (21) besagter Block (29) entworfen um eine übersetzende Bewegung in Richtung des Innen-Gehäuses zu vollziehen (30), welche auf der korrespondierenden Seite des Platten ähnlichen Körpers fixiert ist (11) , um die genannte Extraktionsöffnung zu klären, durch Verwendung eines Griff-Körpers (31), der gemeinsam verbunden ist um elastisch kontrastierenden Schub im genannten Gehäuse herzustellen (30) und zwischen dem internen Ende des Blocks (29) und der unteren Wand (33) des Sitzes des Blocks innerhalb des Gehäuses (30) zwischengeschaltet zu werden.

6. Das Konnektor unterstützte Shuttle nach mindestens einer der vorangegangenen Ansprüche, gekennzeichnet in den benannten Mitteln (16) zur Sperrung der Konnektoren auf mindestens einer Konnektor Unterstützungsplatte (12, 15) werden konstituiert, für jede Konnektor Unterstützungsplatte, durch eine Reihe von seitlich angrenzenden Schieber (33), die durch einen Schieber-Block unterstützt werden (34), der wiederum an den Platten-ähnlichen Körper befestigt ist (11).

7. Das Konnektor unterstützte Shuttle nach Anspruch 6, gekennzeichnet im besagtem Schieber Block (34) wird durch eine Basis unterstützt (35) die zur Befestigung in einem korrespondierendem Sitz eingefügt werden kann (36) definiert in besagtem Platten-ähnlichem Körper (11), die Länge des genannten Sitz wird größer als die Länge der genannten Basis sein.

8. Das Konnektor unterstützte Shuttle nach Anspruch 7, gekennzeichnet zwischen der benannten Basis (35) und des korrespondierenden Schieber Blocks (34) umkehrende Mittel (37) werden zwischengeschaltet zur Beibchaltung des Schieber-Blocks (34) in einer ersten aktiven Konfiguration für das Sperren der Konnektoren, der Abzug der genannten Retention versteht man als Definition der Retraktion des genannten Schieber Blocks (34) in eine zweite inaktive Konfiguration für Konnektoren Entladung.

9. Konnektor unterstützte Shuttle nach Anspruch 8, gekennzeichnet in den genannten Umkehrungs- Mittel (37) zur Beibeihaltung des Schieber-Blocks sind durch ein Vollhub Gerät konstituiert, dass ein Sperren der hinteren Elemente einschließt(38), welches in der Sperr-Konfiguration durch unterliegende elastische Mittel nach oben gedrückt wird, so arrangiert um den korrespondierenden Sitz zu steuern (40) definiert in besagter Basis (35), die den Schieber-Block unterstützt (34), besagter Schieber Block hat einen unteren Teil (41), der so eingesetzt wird um eine übersetzende Bewegung in einer korrespondierenden Lenkung auszuführen (42) ebenso definiert auf besagter Basis (35), wo in besagter Lenkung (42) zusätzliche elastische Mittel angeordnet sind welche angepasst werden um den Schieber- Block zu drücken und zu betätigen (34) um in Bezug auf die Konnektor unterstützte Platte zurückzuziehen (12, 13, 15), vom genannter aktiver Konfiguration zur benannten inaktiven Konfiguration, wenn das genannte Sperr Element einmal (38) gesenkt worden ist, um in den korrespondierenden Sitz zurückzuziehen (40)durch Kompression der unterliegenden elastischen Mittel, bis ein Teil des zurückziehenden Hubs für besagten Schieber unterstützenden Blocks freigelassen wird, besagtes Sperr Element (38) mit einem oberen Teil (44) das von genannter Basis heraus ragt (35) in der unteren Konfiguration und adaptiert ist um als Hub Limitierung zur Retraktion des Schieber-Blockes zu handeln.

## Revendications

1. La navette porte-connecteurs (10) pour les machines automatiques pour la réalisation de câblages électriques, la navette porte-connecteurs comprend un corps de forme plate (11) portant au moins une première plaque porte-connecteurs (12), pour un premier système de connecteurs (C1), reliée audit corps de forme plate (11) avec des dispositifs de fixage réversibles pour le retrait éventuel et la substitution de la première plaque porte-connecteurs même (12) avec une autre seconde plaque porte-connecteurs (15) profilée pour porter un système ultérieur de connecteurs (C3), la navette porte-connecteurs est **caractérisée par le fait que** ledit corps de forme plate (11) comprenne aussi des dispositifs de blocage (16) pour le blocage des connecteurs sur au moins une plaque porte-connecteurs (12, 15), lesdits dispositifs de blocage (16) étant adaptables aux dimensions des connecteurs portés par la plaque porte-connecteurs en usage, ledit corps de forme plate (11) présentant au moins une partie (17) prédisposée pour le fixage aux dispositifs de mouvement par ledit corps de forme plate même.

2. La navette porte-connecteurs, selon la revendication 1, caractérisée du fait que ladite plaque porte-connecteurs (12) présente un bord à peigne (18), antérieure, ou bien du coté du passage des câbles de câblages, une partie centrale (19) d'appui pour les connecteurs, et une partie postérieure (20) ouverte pour le passage des dispositifs de blocage (16), de la superficie inférieure de ladite plaque se développant au moins une nervure (21) apte à être insérée dans un correspondant guide profilé complémentairement (23), définie sur ledit corps de forme plate (11), accessible d'un côté dudit corps de forme plate (11)

3. La navette porte-connecteurs, selon les revendications précédentes, caractérisée du fait que lesdits dispositifs de fixage réversibles (14) pour le retrait éventuel et la substitution de la première plaque porte-connecteurs même (12) avec une autre seconde plaque porte-connecteurs (15), sont donnés par deux nervures (21, 22) d'au moins une nervure, au moins une d'elles (21) présentant une dent antérieure (25) anti soulèvement, chaque nervure (21, 22) étant destinée à un guide correspondant (23, 24) sur le corps de forme plate (11), sur les côtés dudit corps de forme plate étant présents des dispositifs anti défilement (26) aptes à empêcher le mouvement d'au moins une nervure une fois que celle-ci est insérée dans le guide correspondant, ladite plaque porte-connecteurs (12) étant bloquée entre ces dispositifs anti défilement (26) et, de la partie opposée, une butée de fin de course (27) défini sur le corps de forme plate même.

4. La navette porte-connecteurs, selon la revendication 3, **caractérisée par le fait que** sur ledit corps de forme plate (11) sont définis un premier guide (23) pour ladite première nervure (21) avec une dent antérieure anti soulèvement, et une pluralité de second guides (24, 28) côte à côte et parallèles pour s'occuper, au choix de ladite seconde nervure (22) de la plaque porte-connecteurs.

5. La navette porte-connecteurs selon la revendication 3 ou la revendication 4, qui se **caractérise par le fait que** deux dispositifs anti défilement (26) sont donnés d'un bloc rétractable (29), mis en position d'utilisation, pour intéresser la bouche de défilement de la première nervure (21), dudit bloc (29) étant préposé à être déplacé vers l'intérieur d'un petit carter (30) fixé au côté correspondant du corps de forme plate (11), à libérer ladite bouche de défilement, grâce à une patte de préhension (31) auquel elle est reliée, à l'intérieur dudit petit carter (30) s'y trouvant des dispositifs élastiques de butée interposés entre l'extrémité interne du petit bloc (29) et la paroi de fond (33) du logement du bloc à l'intérieur du petit carter (30).

6. La navette porte-connecteurs, selon une ou plusieurs des revendications précédentes, qui se **caractérise par le fait que** lesdits dispositifs (16) de blocage des connecteurs sur au moins une plaque porte-connecteurs (12, 15) sont donnés pour chaque plaque porte-connecteurs d'une série de dispositifs d'avance placés côte à côte(33) portés par un bloc de dispositifs d'avance (34) fixé lui aussi au corps de forme plate (11).

7. La navette porte-connecteurs selon la revendication 6, qui se **caractérisée par le fait que** le dit bloc de dispositifs d'avance (34) est porté par une base (35) insérable par le fixage dans un logement correspondant (36) défini sur ledit corps de forme plate (11), la longueur dudit logement étant majeure par rapport à la longueur de ladite base.

8. La navette porte-connecteurs selon la revendication 7, qui se **caractérise par le fait que** entre ladite base (35) et le bloc de dispositifs d'avance (34) correspondant, sont interposés des dispositifs réversibles (37), de retenue du bloc de dispositifs d'avance (34) dans une première phase opérationnelle de blocage des connecteurs, le désengagement desdits dispositifs de retenue définissant 1c recul dudit bloc de dispositifs d'avance (34) dans une seconde phase de repos et de décharge des connecteurs.

9. La navette porte-connecteurs selon la revendication 8, **caractérisée par le fait que** lesdits dispositifs réversibles (37) de retenue du bloc de dispositifs d'avance sont donnés d'un dispositif à déclenchement comprenant un élément de blocage (38), postérieur, poussé vers le haut en phase de blocage des dispositifs élastiques sous-jacents posés pour fonctionner dans un logement (40) correspondant défini sur ladite base (35) portant le bloc de dispositifs d'avance (34), ledit bloc de dispositifs d'avance présentant une partie inférieure (41) insérée pour se déplacer dans un guide (42) correspondant toujours défini sur ladite base (35), dans ledit guide (42) étant prêts des dispositifs élastiques ultérieurs aptes à pousser ledit bloc de dispositifs d'avance (34) en arrière par rapport à la plaque porte-connecteurs (12, 13, 15) de ladite phase opérationnelle à ladite phase non opérationnelle une fois abaissé ledit élément de blocage (38), à rentrer dans son correspondant logement (40)avec la compression des dispositifs élastiques sous-jacents, jusqu'à libérer un trait de course en arrière pour ledit bloc porte-connecteurs même, ledit élément de blocage (38) présentant une partie supérieure (44) saillante de ladite base (35) en phase abaissée, apte à faire de fin de course pour le recul du bloc de dispositifs d'avance.
